# DEMANDE DE BREVET EUROPEEN

(11) **EP 2 763 177 A1**
(43) Date de publication de la demande: **06.08.2014**
(21) Numéro de dépôt: 14153839.7
(22) Date de dépôt: 04.02.2014
(51) Int. Cl.: H01L 29/49, H01L 29/423, H01L 21/28, H01L 29/66

(54) **Procédé de fabrication d'un transistor MOS à espaceurs d'air**

(30) Priorité: 04.02.2013 FR 1350941
(71) Demandeur: STmicroelectronics SA, 92120 Montrouge (FR); STMicroelectronics (Crolles 2) SAS, 38920 Crolles (FR); COMMISSARIAT A L'ENERGIE ATOMIQUE ET AUX ENERGIES ALTERNATIVES, 75015 Paris (FR)
(72) Inventeur: Niebojewski, Heimanu, 38000 Grenoble (FR); Morand, Yves, 38000 Grenoble (FR); Le Royer, Cyrille, 38210 Tullins-Fures (FR)
(74) Mandataire: Thibon, Laurent

(57) **Abrégé**

L'invention concerne un transistor MOS comprenant, au-dessus d'un isolant de grille (4), un empilement conducteur de grille (6-7) ayant une hauteur, une longueur et une largeur, cet empilement ayant une partie basse (6) voisine de l'isolant de grille et une partie haute (7 ; 27 ; 50), dans lequel ledit empilement a une première longueur (L1) dans sa partie basse, et une deuxième longueur (L2) inférieure à la première longueur dans sa partie haute.

## Description

### Domaine

La présente invention concerne des transistors MOS et plus particulièrement des transistors MOS à espaceurs d'air.

### Exposé de l'art antérieur

Dans la réalisation d'un transistor MOS, on cherche de façon générale à réduire la consommation à la commutation et à augmenter la rapidité de commutation. Ces paramètres dépendent notamment des capacités grille-source, grille-drain, grille-contact de source et grille-contact de drain.

Ces capacités parasites tendent à devenir particulièrement importantes dans le cas de transistors MOS de très petites dimensions, dans lesquels les longueurs de grille sont inférieures à la centaine de nanomètres et notamment inférieures à 20 nm. En effet, dans ce cas les distances entre la grille, d'une part, et la source, le drain, le contact de source et le contact de drain, d'autre part, deviennent extrêmement faibles. Une solution pour réduire ces capacités parasites consiste à entourer les côtés de la grille de part et d'autre de la longueur de celle-ci d'espaceurs d'air (de vide) et non pas de façon classique d'espaceurs en un matériau diélectrique solide. Ceci est par exemple décrit dans l'article "Air Spacer MOSFET Technology for 20nm Node and Beyond" de Jemin Park et Chenming Hu 9th ICSICT - 20-23 octobre 2008 - IEEE 2008.

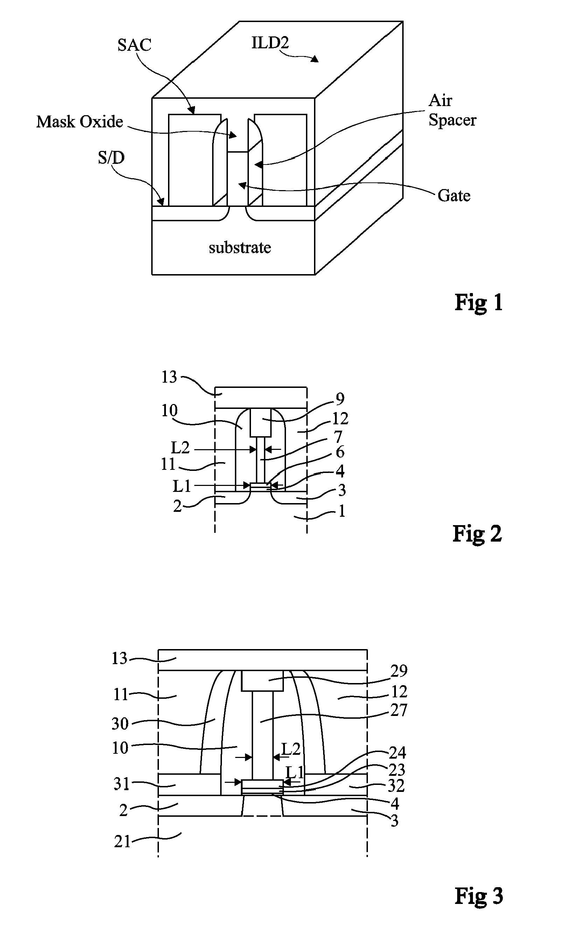

La figure 1 ci-jointe reproduit la figure 3(d) de cet article. On y voit un transistor MOS à une étape intermédiaire de fabrication. Ce transistor est formé sur un substrat (substrate) recouvert d'un empilement de grille (gate). De part et d'autre de la grille sont formées des régions de source et de drain (S/D). La face supérieure de la grille porte un oxyde (Mask Oxide). La grille et l'oxyde qui la recouvrent sont entourés d'espaceurs d'air (Air Spacer). De part et d'autre de ces espaceurs on trouve des régions de contact autoalignées (SAC) contactant respectivement les régions de source et de drain. L'ensemble de la structure est revêtu d'une couche isolante (ILD2). Les espaceurs d'air illustrés en figure 1 résultent de l'élimination par gravure d'espaceurs diélectriques formés préalablement de part et d'autre de la grille.

Cet article ne constitue qu'un exemple de documents de l'état de la technique concernant des structures à espaceurs d'air. On pourrait aussi mentionner les brevets US 6001695 de Texas Instruments et 7132342 de National Semiconductor.

Il serait souhaitable de réduire encore les capacités parasites de grille d'un transistor MOS à espaceurs d'air.

### Résumé

Ainsi, un mode de réalisation de la présente invention prévoit un transistor MOS comprenant, au-dessus d'un isolant de grille, un empilement conducteur de grille ayant une hauteur, une longueur et une largeur, cet empilement ayant une partie basse voisine de l'isolant de grille et une partie haute, dans lequel ledit empilement a une première longueur dans sa partie basse, et une deuxième longueur inférieure à la première longueur dans sa partie haute.

Selon un mode de réalisation, la deuxième longueur est égale à 0,3 à 0,9 fois la première longueur.

Selon un mode de réalisation, l'empilement conducteur de grille est bordé d'espaceurs d'air s'étendant dans la direction de sa largeur.

Selon un mode de réalisation, l'empilement conducteur de grille est en outre bordé d'espaceurs diélectriques, délimitant les espaceurs d'air.

Selon un mode de réalisation, la partie basse de l'empilement conducteur de grille comprend au moins une couche d'un premier matériau, et la partie haute comprend au moins un deuxième matériau.

Selon un mode de réalisation, la partie basse comprend une portion d'une couche d'un métal.

Selon un mode de réalisation, la partie haute comprend une portion d'une couche d'un semiconducteur dopé.

Selon un mode de réalisation, la couche d'un semiconducteur dopé est une couche de silicium ou de silicium-germanium polycristallin.

Selon un mode de réalisation, la partie basse de l'empilement conducteur de grille comprend une couche d'un métal ou d'un alliage métallique et une couche de silicium polycristallin dopé, et la partie haute comprend une couche de silicium-germanium polycristallin dopé.

Selon un mode de réalisation, la partie basse de l'empilement conducteur de grille comprend une couche d'un premier métal ou alliage métallique, et la partie haute comprend une couche d'un deuxième métal ou alliage métallique.

Il est aussi prévu un procédé de fabrication d'un transistor MOS comprenant, au-dessus d'un isolant de grille, un empilement conducteur de grille ayant une hauteur, une longueur et une largeur, ce procédé comprenant les étapes suivantes :
former autour d'un empilement de grille au moins un premier espaceur entouré d'un autre matériau ;
éliminer le premier espaceur pour former une cavité ;
réduire la longueur d'une partie haute de l'empilement de grille ;
boucher l'ouverture supérieure de la cavité par un procédé non conforme tout en assurant un dépôt d'un diélectrique sur les parois de l'empilement de grille ; et
éliminer les constituants de l'empilement de grille et les remplacer par un métal conducteur.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 reproduit la figure 3(d) de l'article susmentionné de Park et al. ;
la figure 2 est une vue en coupe représentant un premier mode de réalisation d'un transistor MOS à espaceurs d'air ;
la figure 3 est une vue en coupe représentant un deuxième mode de réalisation d'un transistor MOS à espaceurs d'air ; et
les figures 4A à 4D sont des vues en coupe représentant des étapes successives d'obtention d'un troisième mode de réalisation de transistors MOS à espaceurs d'air.

Comme cela est habituel dans la représentation des circuits intégrés, les diverses figures ne sont pas tracées à l'échelle.

### Description détaillée

L'utilisation d'espaceurs d'air présente l'avantage par rapport à l'utilisation d'espaceurs diélectriques solides que l'air (ou le vide) présente une très faible constante diélectrique, voisine de 1, alors que les matériaux couramment utilisés dans le domaine de la microélectronique pour les espaceurs, tels que l'oxyde de silicium ou le nitrure de silicium présentent des constantes diélectriques supérieures à 2,5, voire 4. De plus, il est généralement souhaitable de réduire la dimension des espaceurs, d'une part pour la simplicité de leur réalisation, d'autre part pour minimiser les dimensions des composants auxquels ces espaceurs sont associés.

Comme on le notera à partir d'une analyse des divers documents décrivant des espaceurs d'air, ces espaceurs sont obtenus en réalisant d'abord des espaceurs à diélectrique solide puis en éliminant par gravure ces espaceurs et en bouchant la partie supérieure de la cavité ainsi formée. Les dimensions générales des espaceurs sont donc imposées par la technologie.

Par ailleurs, on considère généralement le cas où le transistor que l'on cherche à fabriquer est un transistor de dimensions minimales, c'est-à-dire que la longueur de grille (la dimension considérée dans la direction allant de la source au drain) du transistor correspond à la plus faible dimension que l'on peut obtenir dans une technologie considérée. Ainsi, la longueur de la grille au niveau de son contact avec l'isolant de grille est imposée par la technologie.

De façon générale, la grille est réalisée sous forme d'un empilement de matériaux conducteurs, la hauteur de la grille étant choisie, notamment, pour permettre d'assurer un contact vers le haut, sensiblement au même niveau que les contacts vers les zones de source et de drain.

On propose ici de former une grille classique, puis de réduire la longueur de sa partie supérieure sans changer les autres dimensions de la structure. Il en résulte que, sur la partie de longueur réduite, la distance entre la grille et les contacts de source et de drain est augmentée, d'où il résulte une diminution de la valeur des capacités grille-contact de source et grille-contact de drain et éventuellement des capacités grille-source et grille-drain.

La figure 2 représente de façon schématique une modification de la structure représentée en figure 1, incorporant les principes exposés ci-dessus. On retrouve en figure 2 un substrat 1 dans lequel sont formées des régions de source et de drain 2 et 3 de part et d'autre d'une grille conductrice formée sur un isolant de grille 4. La grille comprend une partie inférieure ou partie basse 6 de longueur L1 en au moins un premier matériau conducteur surmontée d'une partie haute 7 en au moins un deuxième matériau conducteur de longueur L2 inférieure à L1. La partie de grille supérieure ou partie haute est surmontée d'un isolant 9 de même longueur L1 que la partie de grille basse 6. La structure de grille comprenant la grille conductrice 6-7 et l'isolant supérieur 9 est entourée latéralement d'espaceurs 10. Ces espaceurs sont, comme dans le cas de la figure 1, des espaceurs vides ou espaceurs d'air 10. De part et d'autre des espaceurs d'air se trouvent des régions conductrices 11 et 12, respectivement de contact de source et de contact de drain. L'ensemble de la structure est revêtu d'une couche isolante 13.

On comprendra que divers procédés peuvent être utilisés pour obtenir la structure de la figure 2. Tout d'abord, on aura pu procéder exactement de la même façon que pour l'obtention de la structure de la figure 1 mais, avant de boucher par la couche isolante 13 les ouvertures débouchant dans les parties supérieures des espaceurs vides 10, on aura procédé à une attaque par un produit sélectif permettant d'attaquer la partie de grille haute 7. On aura aussi pu former d'abord la grille comprenant la partie basse 6 de longueur L1 et la partie haute 7 de longueur L2 inférieure à L1 et réaliser ensuite seulement des espaceurs en un matériau diélectrique qui, après formation des régions de contact de drain et de source 11 et 12 et avant formation de la couche d'obturation 13, auront été éliminés par gravure sélective.

La structure décrite ci-dessus dérive directement de la structure décrite dans l'article "Air Spacer MOSFET Technology for 20nm Node and Beyond" de Jemin Park et Chenming Hu 9th ICSICT - 20-23 octobre 2008 - IEEE 2008. Cette structure est susceptible de nombreuses variantes. Le deuxième matériau conducteur de la partie de grille haute 7 pourra être un matériau semiconducteur dopé. Cette partie de grille haute 7 pourra être surmontée d'un matériau conducteur plutôt que d'un isolant 9. A un stade intermédiaire de fabrication les zones désignées par les références 11 et 12 pourront être des régions isolantes.

Il est clair qu'une structure du type de celle représentée en figure 2 aura de plus faibles capacités grille-contact de drain et grille-contact de source qu'une structure telle que celle de la figure 1 en raison de l'augmentation de la distance entre la partie de grille haute et les zones de contact de source et de contact de drain.

La figure 3 représente un autre mode de réalisation d'un transistor MOS à espaceurs d'air à faibles capacités parasites. Comme précédemment, la structure comprend des régions de source et de drain 2 et 3 et une couche d'isolement de grille 4. Les zones de source et de drain 2 et 3 peuvent être formées dans une partie de la surface supérieure d'un substrat semiconducteur massif ou bien dans une couche mince de silicium monocristallin formée sur un isolant, lui-même généralement formé sur un substrat semiconducteur non représenté pour constituer une structure dite de silicium sur isolant couramment désignée par le sigle SOI. Ainsi, la référence 21 désigne ou bien un substrat semiconducteur, ou bien une couche isolante. La partie basse de l'empilement conducteur de grille comprend deux régions conductrices 23 et 24, la région inférieure 23 étant de préférence en un métal ou alliage métallique, la région supérieure, optionnelle, étant de préférence en un matériau semiconducteur dopé. La partie haute 27 de l'empilement conducteur de grille est en un matériau conducteur sélectivement gravable par rapport aux matériaux conducteurs 23 et 24. Cette partie haute 27 a une longueur L2 inférieure à la longueur L1 de la partie basse 23-24. La couche intermédiaire 24 est prévue pour améliorer le contact entre la partie haute 27 et la partie inférieure 23 et assurer que la partie basse de la grille est bien équipotentielle. Comme précédemment, la structure est surmontée d'une région 29, isolante ou conductrice, qui, dans l'exemple représenté, est de même longueur L1 que la partie basse 23-24 de cet empilement de grille. La structure de grille est entourée d'un espaceur d'air 10, lui-même entouré d'un deuxième espaceur 30 en un matériau diélectrique solide. On a également représenté, au-dessus des régions de source et de drain, des zones semiconductrices de source et de drain 31, 32, couramment prévues dans le cas où la couche 2 est une couche très mince de silicium sur isolant. A l'extérieur des espaceurs 30 se trouvent les régions de contact de source et de drain 11 et 12 et l'ensemble est surmonté d'une couche isolante 13.

La structure peut être obtenue par un procédé sensiblement identique à celui décrit en relation avec la figure 2. Après la formation d'un premier espaceur qui sera remplacé par l'espaceur d'air, sont formées des régions épitaxiées 31 et 32 d'épaississement des régions de source et de drain. Le deuxième espaceur 30 est formé ensuite puis le premier espaceur intermédiaire est éliminé par gravure pour former l'espaceur d'air 10. On peut aussi éliminer les deux espaceurs pour former un espaceur d'air plus grand.

De nombreux types de matériaux peuvent être utilisés pour réaliser la structure. A titre d'exemple, on considèrera que :
- la couche 21 est une couche d'isolant sur silicium,
- les régions 31 et 32 sont des couches épitaxiées de silicium,
- l'isolant de grille est un matériau à haute permittivité, par exemple HfSiON,
- la couche inférieure 23 de l'empilement conducteur de grille est un métal, ou un composé métallique tel que TiN,
- la couche intermédiaire 24 de l'empilement conducteur de grille est du silicium polycristallin dopé,
- la partie haute 27 de l'empilement conducteur de grille est en silicium-germanium.

Si le premier espaceur qui est remplacé par la cavité vide est en nitrure de silicium, le deuxième espaceur 30 peut être en oxyde de silicium.

On rappellera que l'on pourra également envisager une structure du type de celle de la figure 2 ne comprenant pas de deuxième espaceur.

A titre d'exemple de dimensions :
- la longueur de grille, c'est-à-dire la longueur L1 des régions 23 et 24, peut être de l'ordre de 14 nm,
- la hauteur de l'empilement conducteur de grille peut être de l'ordre de 30 à 60 nm, les couches 23 et 24 ayant par exemple des épaisseurs de 5 nm et la couche 27 une épaisseur de 40 nm,
- la longueur L2 de la partie haute de grille peut être de l'ordre de 5 à 10 nm ou plus généralement de l'ordre de 30 à 90 % de la longueur L1 de la base de l'empilement de grille,
- les espaceurs peuvent avoir des étendues dans le sens de la longueur de 5 à 50 nm.

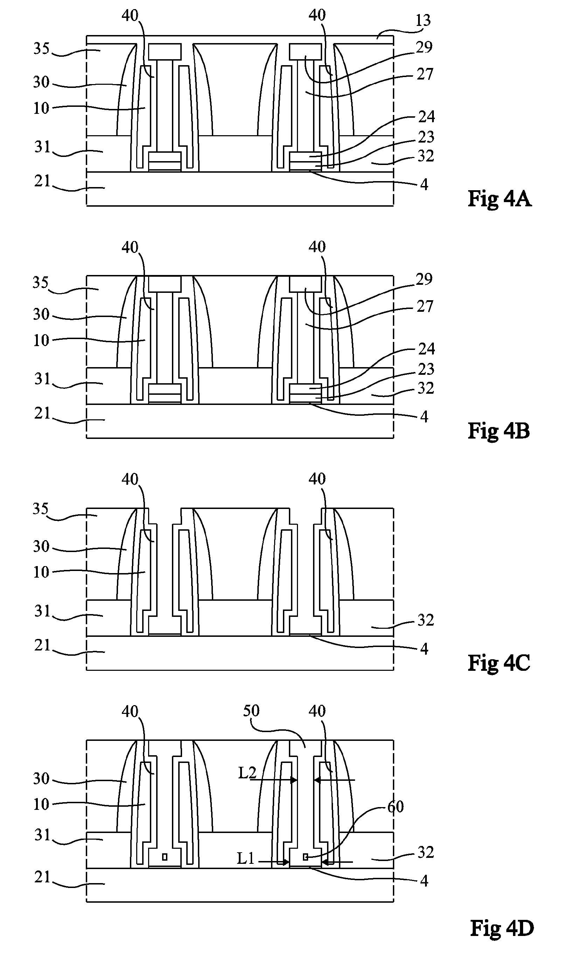

Les figures 4A à 4D représentent des étapes successives de fabrication d'un autre mode de réalisation de transistor MOS à espaceurs d'air à faibles capacités grille-source et grille-drain. Ces figures sont des vues en coupe représentant deux transistors côte à côte, le drain de l'un étant relié à la source de l'autre.

Chacune des structures de la figure 4A est sensiblement identique à celle de la figure 3 et de mêmes éléments y sont désignés par de mêmes références. Toutefois, deux différences apparaissent entre la représentation de la figure 4A et celle de la figure 3.
- D'une part, en figure 4A, les régions 11-12 de contact de source et de contact de drain sont remplacées par des régions isolantes 35. Il s'agit d'une étape antérieure à la formation des régions de contact de drain et de source. L'homme de l'art notera que certaines de ces étapes pourront être réalisées dans des ordres différents.
- D'autre part, on a représenté que, pendant la première partie du dépôt du matériau de la couche 13 sur une épaisseur supérieure à la moitié de la dimension de l'ouverture haute de la cavité de façon à fermer cette ouverture, une mince couche 40 de ce matériau a été formée sur toutes les surfaces de ces cavités.

La figure 4B représente la structure de la figure 4A après enlèvement par gravure mécano-chimique (CMP) de la couche isolante supérieure 13.

A l'étape illustrée en figure 4C, on a éliminé tous les éléments conducteurs de l'empilement de grille. Plus particulièrement on a éliminé la partie isolante 29, la partie conductrice haute 27, la partie intermédiaire 24 et la couche conductrice inférieure 23. Éventuellement, l'isolant de grille 4 est éliminé et un nouvel isolant de grille est redéposé.

A l'étape illustrée en figure 4D, on a déposé un nouveau métal de grille 50 par un procédé physique ou chimique conforme, ce métal peut être choisi dans le groupe comprenant W, Ti et TiN. Le dépôt du métal 50 peut être précédé d'une étape de dépôt d'une couche d'isolement de grille. On notera que, dans cette réalisation, il peut apparaître une bulle d'air 60 à l'emplacement représenté.

Des modes de réalisation particuliers ont été décrits. Diverses variantes et modifications apparaîtront à l'homme de l'art. En particulier, la présente description a été faite en mentionnant des transistors MOS. On comprendra que le terme "transistor MOS" doit être interprété au sens large et couvre notamment les cas où la structure concernée constitue un transistor de commutation ou un point mémoire, et une structure à simple ou double grille. Bien que l'on ait décrit et représenté ici uniquement des transistors MOS dans lesquels les contacts de source et de drain sont auto-alignés sur les espaceurs de grille, la présente demande vise aussi le cas de contacts non auto-alignés.

On notera en outre que les structures décrites et représentées ici le sont à des stades intermédiaires de fabrication. Des étapes ultérieures pourront sans difficultés être mises en oeuvre par l'homme de l'art du domaine de la fabrication des circuits intégrés, notamment en ce qui concerne la réalisation d'éventuelles étapes de siliciuration.

De plus, divers modes de réalisation avec diverses variantes ont été décrits ci-dessus. L'homme de l'art pourra combiner divers éléments de ces divers modes de réalisation et variantes sans faire preuve d'activité inventive.

## Revendications

1. Procédé de fabrication d'un transistor MOS comprenant, au-dessus d'un isolant de grille, un empilement conducteur de grille ayant une hauteur, une longueur et une largeur, ce procédé comprenant les étapes suivantes :
former autour d'un empilement de grille (23, 24, 27, 29) au moins un premier espaceur en un premier matériau entouré d'un autre matériau ;
éliminer le premier espaceur pour former une cavité (10) ;
réduire la longueur d'une partie haute de l'empilement de grille ;
boucher l'ouverture supérieure de la cavité par un procédé non conforme tout en assurant un dépôt d'un diélectrique (40) sur les parois de l'empilement de grille ; et
éliminer les constituants de l'empilement de grille et les remplacer par un métal conducteur (50).

2. Procédé selon la revendication 1, dans lequel la deuxième longueur (L2) est égale à 0,3 à 0,9 fois la première longueur (L1).

3. Procédé selon la revendication 1 ou 2, dans lequel l'empilement conducteur de grille est bordé d'espaceurs d'air (10) s'étendant dans la direction de la largeur.

4. Procédé selon la revendication 3, dans lequel l'empilement conducteur de grille est en outre bordé d'espaceurs diélectriques (30), délimitant les espaceurs d'air.

5. Procédé selon l'une quelconque des revendications 1 à 4, dans lequel la partie basse de l'empilement conducteur de grille comprend au moins une couche d'un premier matériau, et la partie haute comprend au moins un deuxième matériau.

6. Procédé selon la revendication 5, dans lequel la partie basse comprend une portion d'une couche d'un métal.

7. Procédé selon la revendication 5 ou 6, dans lequel la partie haute comprend une portion d'une couche d'un semiconducteur dopé.

8. Procédé selon la revendication 7, dans lequel la couche d'un semiconducteur dopé est une couche de silicium ou de silicium-germanium polycristallin.

9. Procédé selon l'une quelconque des revendications 1 à 4, dans lequel la partie basse de l'empilement conducteur de grille comprend une couche d'un métal ou d'un alliage métallique et une couche de silicium polycristallin dopé, et la partie haute comprend une couche de silicium-germanium polycristallin dopé.

10. Procédé selon l'une quelconque des revendications 1 à 4, dans lequel la partie basse de l'empilement conducteur de grille comprend une couche d'un premier métal ou alliage métallique (23), et la partie haute comprend une couche d'un deuxième métal ou alliage métallique (50).
